Europäisches Patentamt

European Patent Office

Office européen des brevets

(19)

(11) Numéro de publication: **0 007 280**
**A1**

(12) **DEMANDE DE BREVET EUROPEEN**

(21) Numéro de dépôt: **79400488.7**

(22) Date de dépôt: **10.07.79**

(51) Int. Cl.³: **H 03 K 17/975**
**H 01 H 13/00**

(30) Priorité: **13.07.78 FR 7821076**

(43) Date de publication de la demande:
**23.01.80 Bulletin 80/2**

(84) Etats Contractants Désignés:
**AT BE CH DE GB IT LU NL SE**

(71) Demandeur: **Lewiner, Jacques**
**5, rue Bory d'Arnex**
**F-92210 Saint-Cloud(FR)**

(71) Demandeur: **Hennion, Claude**
**50, rue de la Clef**
**F-75005 Paris(FR)**

(72) Inventeur: **Lewiner, Jacques**
**5, rue Bory d'Arnex**
**F-92210 Saint-Cloud(FR)**

(72) Inventeur: **Hennion, Claude**
**50, rue de la Clef**
**F-75005 Paris(FR)**

(74) Mandataire: **Behaghel, Pierre et al,**
**CABINET PLASSERAUD 84 rue d'Amsterdam**
**F-75009 Paris(FR)**

(54) Perfectionnements aux dispositifs de commande électrique du genre des boutons-poussoirs.

(57) Il s'agit d'un bouton-poussoir travaillant par variation de capacité d'un condensateur.

Ce condensateur est constitué par deux armatures, l'une mobile 6 montée sur le bouton 1 et l'autre fixe 7, s'étendant parallèlement l'une à l'autre parallèlement à la direction de déplacement du bouton de façon telle que ce déplacement fasse varier l'importance des plages en regard des armatures sans modifier leur écartement. Un électret 11 est avantageusement rapporté sur l'une des armatures.

Applications courantes.

Figure 1.

EP 0 007 280 A1

Fig.1.

Perfectionnements aux dispositifs de commande
électrique du genre des boutons-poussoirs


L'invention est relative aux dispositifs de commande du genre des "boutons-poussoirs", c'est-à-dire comprenant d'une part un bouton, touche ou organe analogue - appelé "bouton" dans la suite - déplaçable par l'actionnement d'un doigt à l'encontre d'un effort de rappel et d'autre part des moyens pour exploiter les déplacements de ce bouton à des fins de commande électrique, notamment par émission d'un signal ou par fermeture ou ouverture d'un circuit.

Elle vise plus particulièrement, parmi ces dispositifs de commande, ceux qui travaillent par variation de capacité d'un condensateur à deux armatures parallèles dont l'une est fixe et dont l'autre, mobile, est liée au bouton (solution qui supprime les contacts mécaniques, les étincelles inhérentes à ce type de contact et les usures résultant de ces étincelles), et plus particulièrement encore ceux des dispositifs de commande en question, dans lesquels les surfaces mutuellement en regard des deux armatures parallèles s'étendent parallèlement à la direction de déplacement du bouton (solution qui permet de donner au bouton une course de commande relativement grande, savoir au moins égale à 4 mm, et donc de lui associer des moyens propres à faire ressentir sans équivoque à l'usager que la commande désirée a bien été effectuée).

Les dispositifs de commande connus de ce genre donnent certaines satisfactions.

Mais les variations de capacité engendrées par les commandes en question ne peuvent être exploitées qu'en association avec des signaux électriques extérieurs, signaux qui sont alors modifiés par lesdites variations de capacité ; de plus, il est difficile de donner à ces variations des valeurs importantes vu qu'il est nécessaire de réserver en permanence entre les armatures un écartement suffisant (par exemple de l'ordre de 0,5 mm) pour éviter les risques de contacts mécaniques entre ces armatures.

Pour écarter ces inconvénients, selon l'invention, on prévoit un électret s'étendant sur une partie au moins de l'une des armatures en regard de l'autre.

Un électret est une feuille diélectrique chargée électriquement en permanence.

L'actionnement d'un tel dispositif de commande équipé d'un électret a pour effet de modifier la charge induite sur les armatures du condensateur, ce qui crée un courant ou une tension électrique directement exploitable sans nécessiter le recours à un signal électrique extérieur ; de plus, cette modification de charge n'est pas fondamentalement influencée par l'écartement entre les armatures, lequel peut donc être relativement important et atteindre ou même dépasser sans inconvénient 0,5 mm.

Dans des modes de réalisation préférés, on a recours en outre à l'une et/ou à l'autre des dispositions suivantes :

- les armatures de chaque condensateur sont planes,

- les armatures de chaque condensateur sont constituées par des cylindres coaxiaux ou portions de tels cylindres,

- le dispositif de commande comprend deux armatures fixes propres à coopérer simultanément avec l'électrode mobile lors de ses déplacements,

- le dispositif de commande comprend deux armatures fixes se succédant selon la direction du déplacement de l'armature mobile et propres à coopérer successivement avec cette dernière lors de ses déplacements,

- le dispositif de commande comprend des moyens de rappel de forces différentes pour s'opposer aux déplacements du bouton dans deux portions successives de sa course,

- l'électret est lié à l'électrode mobile,

- l'électret est lié à une électrode fixe,

- le bouton est une touche prévue à la tête d'une lame élastiquement flexible à pied fixe,

- dans un dispositif selon l'alinéa précédent, l'armature mobile est constituée par l'extrémité libre rabattue de la lame élastique, cette extrémité étant notamment ajourée.

L'invention comprend, mises à part ces dispositions principales, certaines autres dispositions qui s'utilisent de préférence en même temps et dont il sera plus explicitement question ci-après.

Dans ce qui suit, l'on va décrire quelques modes de réalisation préférés de l'invention en se référant au dessin ci-annexé d'une manière bien entendu non limitative.

La figure 1 de ce dessin montre schématiquement un dispositif de commande électrique établi selon l'invention.

Les figures 2 à 6 montrent en vue perspective partielle respectivement cinq variantes conformes à l'invention d'un tel dispositif de commande.

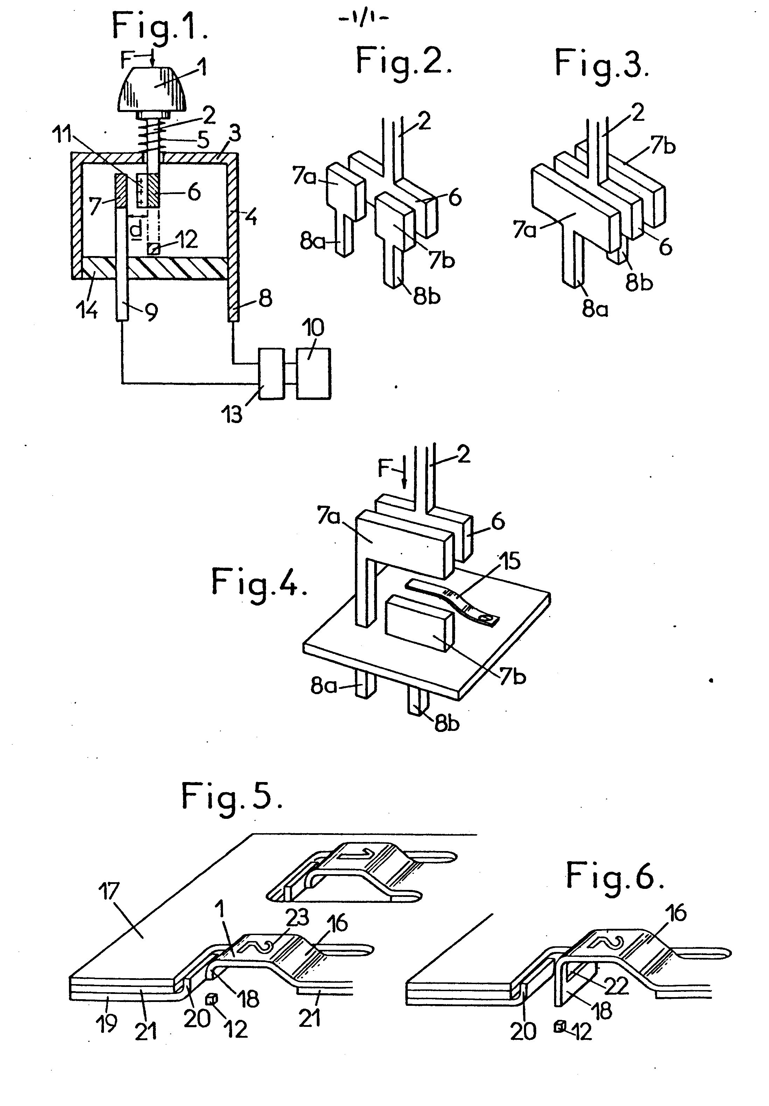

Le dispositif de commande schématisé sur la figure 1 comprend :

- un bouton 1 calé sur l'extrémité d'une tige 2 elle-même montée de façon à pouvoir coulisser axialement dans un alésage cylindrique complémentaire solidaire du capot 3 d'un boîtier 4,

- un ressort hélicoïdal de compression 5 monté autour de la tige 2 entre le capot 3 et le bouton 1 de façon à solliciter en permanence ce dernier à s'écarter du boîtier 4,

- une première armature de condensateur 6 portée par l'extrémité de la tige 2 intérieure au boîtier,

- et une deuxième armature de condensateur 7 fixe, c'est-à-dire solidaire du boîtier.

Les deux armatures 6 et 7 sont ici constituées par des plaquettes rectangulaires s'étendant parallèlement à la direction des déplacements du bouton et parallèlement l'une à l'autre, à une distance $d$ l'une de l'autre.

Ces deux armatures 6 et 7 sont connectées électriquement à deux bornes 8 et 9, elles-mêmes reliées à un circuit d'exploitation 10, la liaison entre l'armature 6 et la borne 8 étant assurée notamment par l'intermédiaire de la suite des éléments suivants qui sont alors prévus conducteurs de l'électricité : tige 2, base du bouton 1, ressort 5 et boîtier 4.

Des butées de fin de course (telles que 12) sont prévues pour limiter la course du bouton 1 à ses deux extrémités.

Enfin, on polarise le condensateur en prévoyant sur l'une des deux faces en regard de ses armatures 6 et 7 un électret 11, c'est-à-dire une feuille diélectrique chargée électriquement.

L'électret en question est avantageusement réalisé à partir d'une feuille en polyoléfine substituée ou en polymère fluoré d'épaisseur comprise entre quelques microns et quelques millimètres. Cette feuille est chargée électriquement, au moins au voisinage de l'une de ses deux faces, par des charges positives, comme représenté à titre d'exemple par les symboles + sur la figure 1, ou par des charges négatives.

Le fonctionnement du dispositif de commande ainsi défini est le suivant :

Pour la position de repos, c'est-à-dire totalement sortie, du bouton 1, la surface des plages mutuellement en regard de l'électret 11 et de l'armature 6 ou 7 dont il n'est pas solidaire est ici maximum, ainsi donc que la charge induite par cet électret sur cette armature.

Si, à l'aide d'un doigt, on appuie sur le bouton 1 en contrariant l'effort de rappel du ressort 5, on réduit progressivement la surface desdites plages en regard pour finalement l'annuler (position schématisée en pointillés sur la figure 1), ce qui réduit en correspondance la charge induite considérée.

Lors du lacher subséquent du bouton 1, la détente du ressort 5 ramène ce bouton à sa position initiale en faisant croître à nouveau jusqu'à sa valeur maximum la surface des plages en regard ci-dessus et la charge induite correspondante.

Au lieu de prévoir pour cette surface une valeur maximum au repos, on pourrait également prévoir l'inverse, savoir une valeur minimum, voire nulle, au repos, ladite surface croissant alors quand on appuie sur le bouton 1 et inversement, l'écartement mutuel $d$ entre les deux armatures demeurant constant dans tous les cas.

Mais la première variante présente l'avantage d'une moindre sensibilité du dispositif aux parasites extérieurs pour sa position normale de repos, ce qui peut être avantageux pour certaines utilisations.

Selon encore une autre variante, on peut prévoir que, pour une même commande, le déplacement continu à vitesse constante du bouton dans un sens corresponde à une variation non linéaire de la surface ci-dessus, la loi de cette variation pouvant même passer par une valeur extrême maximum ou minimum pour un point intermédiaire de la course de commande : une telle variante peut être intéressante par exemple pour coder sélectivement les différentes touches d'un clavier.

Dans tous les cas, la course de commande du bouton, effectuée parallèlement aux armatures et à l'électret, est relativement importante : elle peut atteindre facilement 4 mm et même davantage, ce qui est souvent recherché pour les applications modernes des boutons-poussoirs.

Les variations de charge induite créées par les déplacements du bouton sont exploitées de toute manière désirable à des fins de commande électrique.

Il convient d'utiliser à cet effet entre le dispositif de commande considéré et le circuit d'exploitation proprement dit des moyens d'adaptation 13 permettant de transformer les faibles signaux analogiques de tension engendrés par les variations de la charge induite ci-dessus en signaux électriques directement exploitables par les circuits logiques ou analogiques usuels.

Comme la capacité du condensatuer 6, 7 est généralement très faible, étant par exemple de l'ordre de 1 à 30 pF, l'impédance d'entrée des circuits en question doit être très élevée et par exemple de l'ordre de $10^{12}$ ohms.

Cette impédance peut être incorporée aux moyens d'adaptation 13 ou, selon une variante intéressante, être réalisée au niveau du bouton-poussoir lui-même en constituant le fond 14 qui supporte directement la borne 9 solidaire de l'armature 7 en une matière plastique chargée de particules conductrices (carbone, cuivre, argent) qui rendent cette matière légèrement conductrice.

Les moyens d'adaptation 13, qui peuvent être eux-mêmes incorporés au boîtier 4, sont avantageusement consti-

tuées par un circuit MOS.

Le nombre de commandes électriques assurées pour chaque appui d'un doigt sur le bouton 1 peut être multiplié en multipliant le nombre des armatures fixes électriquement isolées les unes des autres et reliées à autant de circuits d'exploitation indépendants.

Trois variantes de telles multiplications par deux ont été respectivement illustrées sur les figures 2, 3 et 4 (sur lesquelles l'électret n'a pas été représenté, pour simplifier) :

- sur la figure 2, les deux armatures fixes 7a et 7b sont disposées côte à côte, avec leurs plans moyens confondus, d'un même côté de l'armature mobile 6, et coopèrent chacune avec une portion de la surface de cette armature mobile, cette portion étant sensiblement égale à la moitié de ladite surface,

- sur la figure 3, les deux armatures fixes 7a et 7b sont disposées de part et d'autre de l'armature mobile 6 et encadrent cette dernière,

- sur la figure 4, les deux armatures fixes 7a et 7b sont disposées comme celles de la figure 2, d'un même côté de l'armature mobile 6, avec leurs plans moyens confondus, mais elles se succèdent cette fois-ci selon la direction même de déplacement de l'armature mobile qui a été schématisée par la flèche F.

Dans chacune de ces trois variantes, les deux armatures fixes 7a et 7b considérées sont reliées à leur circuit d'exploitation par respectivement des bornes indépendantes 8a et 8b.

Sur la figure 4, on voit en 15 un ressort qui est situé sur la trajectoire de l'armature mobile 6 et qui est destiné à accroître l'effort de rappel exercé sur cette armature mobile à partir de l'instant où celle-ci parvient en regard de la seconde armature fixe 7b : l'usager ressent alors un "point dur" l'informant de ce que l'actionnement du bouton 1 par son doigt amorce la seconde phase de sa double commande.

Bien entendu, on peut également diviser l'armature

mobile 6 en plusieurs éléments électriquement indépendants les uns des autres et reliés à des circuits d'exploitation différents, mais les connexions électriques indépendantes sont plus faciles à réaliser avec des armatures fixes.

Dans les variantes qui ont été schématisées sur les figures 5 et 6 - variantes pour lesquelles l'électret n'a pas été représenté pour simplifier - le bouton de commande 1 est constitué par une touche prévue à la tête d'une lame 16 élastiquement flexible, dont le pied est encastré dans une ossature fixe, le rappel de la touche en sa position de repos étant assuré par l'élasticité de la lame.

Dans une réalisation avantageuse, cette ossature est constituée par une plaque métallique 17 dans laquelle la lame 16 a été crevée par estampage.

La tête de cette lame présente, au-delà d'un ressaut faisant légèrement saillie sur la lame et constituant la touche proprement dite, un bord 18 rabattu à angle droit.

Une autre lame 19 présentant également un bord 20 rabattu à angle droit, mais dans le sens inverse du précédent, est rapportée sous la plaque 17 avec interposition d'une feuille isolante 21 de façon à présenter son dit bord ou rabat 20 en regard du bord ou rabat 18 au moins lorsque la touche 1 est actionnée, cet actionnement déplaçant ledit rabat 18 parallèlement à sa direction de rabattement, c'est-à-dire perpendiculairement à la surface principale de la lame 16 : ce sont alors les deux rabats 18 et 20 qui constituent les armatures du condensateur dont les variations de charge sont exploitées selon l'invention.

Ici encore, on prévoit des butées de fin de course schématisées en 12.

La variante de la figure 6 diffère de celle de la figure 5 en ce que :

- dans la première, les deux rabats 18 et 20 sont au repos décalés l'un de l'autre selon la direction commune des deux rabattements, la charge à exploiter croissant alors quand la touche est actionnée,

dans la seconde au contraire, les surfaces transversalement en regard des deux rabats 18 et 20 sont maxima lorsque

la touche 1 est au repos et décroît lorsque cette dernière est actionnée du fait de la présence d'une fenêtre 22 évidée dans le rabat 18, ledit actionnement diminuant alors la charge du condensateur.

Une pluralité de touches du genre ci-dessus, identifiées par des chiffres ou caractères 23, peuvent être prévues côte à côte pour constituer un clavier, l'ensemble pouvant être revêtu d'une feuille souple de protection et d'isolation.

Bien entendu, ici encore, l'un au moins des deux rabats 18 et 20 peut être divisé de façon à multiplier les commandes assurées par chaque actionnement de touche.

En suite de quoi et quel que soit le mode de réalisation adopté, on obtient un dispositif de commande électrique présentant de nombreux avantages par rapport à ceux antérieurement connus, et en particulier les suivants : absence de contacts mécaniques, grande course de commande, indépendance vis-à-vis de toute source extérieure de signaux ou de polarisation, facile multiplication des commandes assurées simultanément.

Le fait de pouvoir assurer simultanément deux commandes distinctes par l'actionnement d'un même bouton ou touche est particulièrement avantageux dans le cas où de tels boutons composent un clavier ou matrice de $m$ lignes et $n$ colonnes, chacune des deux commandes pouvant donner une information sur l'une des deux coordonnées (ligne ou colonne) du bouton considéré et permettre ainsi facilement son identification.

Comme il va de soi, et comme il résulte d'ailleurs déjà de ce qui précède, l'invention ne se limite nullement à ceux de ses modes d'application et de réalisation qui ont été plus spécialement envisagés ; elle en embrasse, au contraire, toutes les variantes, notamment :

- celles où les armatures auraient une forme générale autre que plate et rectangulaire, étant par exemple constituées respectivement par des cylindres coaxiaux ou portions de tels cylindres,

- celles où le rappel du bouton vers sa position de repos serait assuré par des moyens élastiques autres qu'un ressort mécanique, par exemple par un aimant,

- celles où un système élastique à dépassement de point mort serait associé au bouton de façon telle que l'actionnement de ce bouton implique le dépassement d'un "point dur", ce dépassement, facilement perceptible par l'usager signalant à celui-ci sans équivoque que la commande désirée par lui est effectivement exécutée,

- celles où l'armature solidaire de l'électret serait constituée par une simple métallisation de ce dernier,

- celles où le nombre des armatures parallèles constituant le condensateur serait supérieur à deux, celui-ci pouvant comporter aussi bien une pluralité d'armatures mobiles qu'une pluralité d'armatures fixes ou les deux à la fois,

- celles où, dans cette hypothèse d'une pluralité d'armatures fixes (et/ou mobiles), le circuit d'exploitation (13, 10) serait relié uniquement à ces armatures fixes (et/ou mobiles), savoir par exemple uniquement aux bornes 8a et 8b et non à la tige 2 dans les cas des figures 2 et 3,

- celles où l'électret ne s'étendrait que sur une partie d'armature métallique, solution qui peut présenter certains avantages, notamment en ce qui concerne la fabrication de ladite armature revêtue de cet électret, ou encore du fait que les variations de capacité alors dues aux déplacements du bouton peuvent être réduites pour des variations de charge données,

- et celles où, dans l'hypothèse ci-dessus d'une pluralité d'armatures fixes (et/ou mobiles), seules certaines de ces armatures seraient revêtues d'un électret, par exemple uniquement l'armature 7a et non l'armature 7b dans les cas des figures 2 et 3.

Revendications de brevet.

1.      Dispositif de commande électrique comprenant d'une part un bouton ou analogue, déplaçable à l'encontre d'un effort de rappel et d'autre part des moyens pour exploiter les déplacements de ce bouton à des fins de commande électrique, moyens travaillant par variation de capacité d'au moins un condensateur à deux armatures parallèles dont l'une est fixe et dont l'autre, mobile, est liée au bouton, les surfaces mutuellement en regard de ces deux armatures s'étendant parallèlement à la direction de déplacement du bouton, caractérisé en ce qu'un électret (11) s'étend sur une partie au moins de l'une des armatures (6) en regard de l'autre (7).

2.      Dispositif de commande selon la revendication 1, caractérisé en ce que les armatures de chaque condensateur sont planes.

3.      Dispositif de commande selon la revendication 1, caractérisé en ce que les armatures de chaque condensateur sont constituées par des cylindres coaxiaux ou portions de tels cylindres.

4.      Dispositif de commande selon l'une quelconque des revendications précédentes, caractérisé en ce qu'il comprend deux armatures fixes (7a, 7b, figure 2 ou 3) propres à coopérer simultanément avec l'électrode mobile (6) lors de ses déplacements.

5.      Dispositif de commande selon l'une quelconque des revendications précédentes, caractérisé en ce qu'il comprend deux armatures fixes (7a, 7b, figure 4) se succédant selon la direction du déplacement de l'armature mobile (6) et propres à coopérer successivement avec cette dernière lors de ses déplacements.

6.      Dispositif de commande selon l'une quelconque des revendications précédentes, caractérisé en ce qu'il comprend des moyens de rappel de forces différentes pour s'opposer aux déplacements du bouton dans deux portions successives de sa course.

7. Dispositif de commande selon l'une quelconque des revendications précédentes, caractérisé en ce que l'électret (11) est lié à l'électrode mobile.

8. Dispositif de commande selon l'une quelconque des revendications 1 à 6, caractérisé en ce que l'électret (11) est lié à une électrode fixe.

9. Dispositif de commande selon l'une quelconque des revendications précédentes, caractérisé en ce que le bouton est une touche prévue à la tête d'une lame élastiquement flexible (16) à pied fixe.

10. Dispositif de commande selon la revendication 9, caractérisé en ce que l'armature mobile est constituée par l'extrémité libre rabattue (18) de la lame élastique, cette extrémité étant notamment ajourée (en 22).

# Fig.1.

F

1

2

5

11

3

6

7

4

d

12

14

9

8

13

10

# Fig.2.

2

7a

6

8a

7b

8b

# Fig.3.

2

7b

7a

6

8b

8a

# Fig.4.

F

2

7a

6

15

8a

8b

7b

# Fig.5.

17

1

23

16

19

21

20

12

18

21

# Fig.6.

16

22

20

12

18

**Office européen des brevets**

**RAPPORT DE RECHERCHE EUROPEENNE**

Numéro de la demande

**EP 79 40 0488**

| Catégorie | Citation du document avec indication, en cas de besoin, des parties pertinentes | Revendication concernée |
|---|---|---|
| | **DOCUMENTS CONSIDERES COMME PERTINENTS** | |
| X | <u>US - A - 3 823 355</u> (BATZ)<br>* Figure 1; colonne 3 à colonne 4, ligne 54 *<br><br>-- | 1,4-6 |
| X | <u>US - A - 3 631 472</u> (LINCOLN)<br>* Figures 2,4; colonne 4, ligne 26 à colonne 6, ligne 21 *<br><br>-- | 1,3,4,6 |
| X | <u>GB - A - 1 375 361</u> (WINSTON ELECTRONICS)<br>* Figures 1-3; page 2, lignes 54-64 *<br><br>-- | 1,5,6 |
| | <u>US - A - 3 935 481</u> (SHOJI UCHIKAWA)<br>* Figures 6,7; colonne 5, ligne 57 à colonne 6, ligne 5 *<br><br>-- | 1,2 |
| A | <u>US - A - 3 958 239</u> (GREEN)<br>* Figures 5,8,12; colonne 7, ligne 55 à colonne 8, ligne 20; colonne 9, lignes 16-62 *<br><br>-- | 1 |
| A | <u>GB - A - 1 151 299</u> (IKOR)<br>* Figures 1-3; page 1, ligne 62 à page 2, ligne 9 *<br><br>---- | 1 |

**CLASSEMENT DE LA DEMANDE (Int. Cl. 4)**

H 03 K 17/975
H 01 H 13/00

**DOMAINES TECHNIQUES RECHERCHES (Int. Cl. 3)**

H 03 K 17/975
17/965

**CATEGORIE DES DOCUMENTS CITES**

X: particulièrement pertinent
A: arrière-plan technologique
O: divulgation non-écrite
P: document intercalaire
T: théorie ou principe à la base de l'invention
E: demande faisant interférence
D: document cité dans la demande
L: document cité pour d'autres raisons
&: membre de la même famille, document correspondant

Le présent rapport de recherche a été établi pour toutes les revendications

| Lieu de la recherche | Date d'achevement de la recherche | Examinateur |
|---|---|---|
| La Haye | 16-10-1979 | LEDRUT |

OEB Form 1503.1  06.78